(19) Europäisches Patentamt
European Patent Office
Office européen des brevets

(11) **EP 2 019 433 A1**

(12) **EUROPEAN PATENT APPLICATION**
published in accordance with Art. 153(4) EPC

(43) Date of publication:
**28.01.2009 Bulletin 2009/05**

(51) Int Cl.:
***H01L 31/04*** *(2006.01)*

(21) Application number: **07741709.5**

(22) Date of filing: **16.04.2007**

(86) International application number:
**PCT/JP2007/058273**

(87) International publication number:
**WO 2007/132616 (22.11.2007 Gazette 2007/47)**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK RS**

(30) Priority: **17.05.2006 JP 2006137974**

(71) Applicant: **Eko Instruments Trading Co., Ltd Tokyo 151-0073 (JP)**

(72) Inventors:
• **HASEGAWA, Toshikazu**
  **Shibuya-ku, Tokyo 151-0073 (JP)**
• **KATO, Tadashi**
  **Shibuya-ku, Tokyo 151-0073 (JP)**

(74) Representative: **Cross, Rupert Edward Blount Boult Wade Tennant Verulam Gardens 70 Gray's Inn Road London WC1X 8BT (GB)**

(54) **APPARATUS FOR EVALUATING CHARACTERISTICS OF SOLAR CELL**

(57) The objective is to perform a more detailed failure diagnosis of a photovoltaic device. Provided is a photovoltaic device characterization apparatus including a measurement unit (30, 36, 38, 40, 42, 44, 46, 48, 50) for measuring current-voltage characteristic of a photovoltaic device, a conversion unit (30) for converting the current-voltage characteristic measured with the measurement unit into a prescribed reference condition, a memory (52) for storing a plurality of reference characteristics, and a determination unit (30) for comparing the current-voltage characteristic converted into the reference condition and the reference characteristics read from the memory, and determining to which one of the reference characteristics the current-voltage characteristic is closest.

*F I G.  1*

**Description**

TECHNICAL FIELD

The present invention relates to technology for characterizing a photovoltaic device.

BACKGROUND ART

In recent years, with global environmental problems attracting attention, photovoltaic systems using solar energy, which is known to be inexhaustible and clean energy, are becoming popular. Japan holds the greatest global market share of photovoltaic systems and, as a part of the domestic countermeasures against global warming, the introduction of solar power systems corresponding to an electric-generating capacity of 4,820,000kW by the year 2010 is targeted.

Pursuant to the diffusion of photovoltaic systems in general households, technology for maintaining and managing the system is becoming important. For example, among the individual solar cells configuring the system, there are cases where certain solar cells are not able to obtain the prescribed output that was initially contemplated due to wiring errors during the installation, influence from shadows caused by neighboring trees or buildings, time degradation and various other factors. Meanwhile, since photovoltaic systems are generally installed on rooftops, there are many instances where the person who purchased the system does not notice the decrease in the generated power that occurs after the system is installed. In addition, since the output of a photovoltaic device fluctuates due to various factors such as the installed condition (angle of inclination, etc.) of the photovoltaic device, season (solar altitude), time (solar intensity), and temperature, it is difficult to determine whether the generated output of the photovoltaic device is correct, and the user often notices an abnormality a while after the installation. Thus, a method of discovering a decrease in output of the photovoltaic system and identifying the location thereof is required.

Although there have been reports concerning the decrease in output of solar cell modules, there are hardly any reports that consider a method of identifying the location causing the decrease in output of a systemized solar cell array (refer to Non-Patent Document 1). For example, there are cases where a tester confirms the open voltage upon installing a residential photovoltaic system (refer to Non-Patent Document 2). Here, even if the open voltage of the photovoltaic system is normal, there are cases when the output is decreased. Thus, it is difficult to accurately diagnose an abnormality in the photovoltaic system with the method using a tester.

[Non-Patent Document 1]
Takashima, et al.: "Fundamental Review of Failure Diagnosis Method of Photovoltaic Array," Collected Papers of Lectures Concerning Solar/Wind Power Generation, 105, pp. 425-428 (2003)
[Non-Patent Document 2] Nishizawa, et al.: "Rudiments of Photovaltaic Power Generation and Residential Application," Riko Tosho K.K., p159 (1998)

DISCLOSURE OF THE INVENTION

Thus, an object of the present invention is to propose technology that enables a more detailed failure diagnosis of a photovoltaic device.

In order to achieve the foregoing object, an aspect of the present invention provides a photovoltaic device characterization apparatus including a measurement unit for measuring a current-voltage characteristic of a photovoltaic device, a conversion unit for converting the current-voltage characteristic measured with the measurement unit into a prescribed reference condition, a memory (storage unit) for storing a plurality of reference characteristics, and a determination unit for comparing the current-voltage characteristic converted into the reference condition and the reference characteristics read from the memory, and determining to which one of the reference characteristics the current-voltage characteristic is closest (i.e., with which one of the reference characteristics the difference is smallest). In addition, preferably, the characterization apparatus further includes a display unit for displaying subject matter of the determination of the determination unit.

According to the foregoing configuration, by preparing reference characteristics of the current-voltage characteristic corresponding to several typical failures and comparing such reference characteristics and the current-voltage characteristic obtained by actually measuring the photovoltaic device, the subject matter of the failure can be estimated. Accordingly, it is possible to conduct a more detailed failure diagnosis of the photovoltaic device.

Preferably, the conversion unit converts the current-voltage characteristic into a reference condition of 1 kW/m$^2$, 25°C.

It is thereby possible to estimate the failure with greater accuracy.

Preferably, the conversion unit acquires the back side temperature and solar intensity of the photovoltaic device, and performs the conversion into the reference condition based on the acquired back side temperature and solar intensity.

Since the conversion to the reference condition can be made by giving consideration to the error caused by the installation environment of the photovoltaic device, it is thereby possible to estimate the failure with greater accuracy.

Preferably, the conversion unit additionally performs processing for normalizing the current-voltage characteristic.

It is thereby possible to estimate the failure with greater accuracy.

The determination unit may compare the current-voltage characteristic and the reference characteristics based on a least square method. Incidentally, other curve regression methods may also be adopted.

As a result of adopting the foregoing method, a simple and highly reliable comparison can be realized.

Preferably, the measurement unit measures the open voltage before measuring the current of the photovoltaic device, and does not measure the current if the open voltage shows an abnormal value.

It is thereby possible to detect an abnormality such as the reverse connection of the photovoltaic device before measuring the current and prevent the characterization apparatus from becoming damaged.

Preferably, the measurement unit sets a voltage range by measuring the open voltage of the photovoltaic device, subsequently measures the current in a maximum range upon connecting a load to the photovoltaic device, and sets the current range based on the obtained value.

It is thereby possible to measure the current and voltage in an auto range.

According to an aspect of the present invention, it is possible to individually estimate and detect the decrease in output of a photovoltaic device caused by wiring errors, ambient environment such as neighboring trees or buildings, time degradation and various other factors.

BRIEF DESCRIPTION OF THE DRAWINGS

Fig. 1 is a diagram explaining the configuration of a solar cell module characterization system according to an embodiment of the present invention;
Fig. 2 is a diagram explaining a circuit configuration example of the solar cell module;
Fig. 3 is a diagram schematically explaining a function of the characterization apparatus;
Fig. 4 is a diagram explaining in detail regarding the current-voltage characteristic (I-V characteristic);
Fig. 5 is a diagram showing an equivalent circuit of the photovoltaic device;
Fig. 6 is a block diagram explaining the detailed configuration of the characterization apparatus;
Fig. 7 is a conceptual diagram explaining data of the reference characteristics;
Fig. 8 is a flowchart explaining the operation routine of the characterization apparatus; and
Fig. 9 is a graph explaining the conversion of the I-V characteristic to a reference condition.

BEST MODE FOR CARRYING OUT THE INVENTION

Embodiments of the present invention are now explained with reference to the attached drawings.

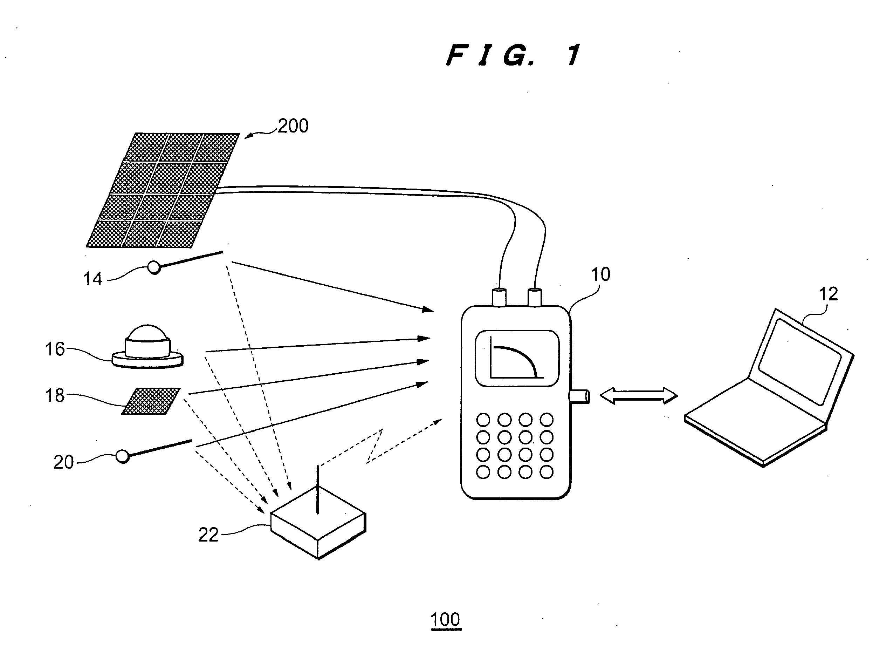

Fig. 1 is a diagram explaining the configuration of a solar cell module characterization system according to an embodiment of the present invention. The characterization system 100 shown in Fig. 1 is for performing the characterization of a solar cell module 200, and is configured from a characterization apparatus 10, a computer 12, thermometers 14, 20, an actinometer 16, and a reference cell 18.

The characterization apparatus 10 is connected to the solar cell module 200 via a wiring, and evaluates the characteristics of the solar cell module and displays the result of such evaluation. The characterization apparatus 10 is connected to the computer 12 via a fixed line such as USB (universal Serial Bus) or a wireless communication means, and is able to transfer the measured characteristic value or the evaluation result to the computer 12. The characterization apparatus 10 of this embodiment is of a size that fits into the hand of a user, and is operable without requiring any external power supply by running on batteries. The characterization apparatus 10 also includes a display unit, and is able to independently measure, evaluate and display the characteristic value of the solar cell module 200 without receiving any operational control of an external apparatus such as the computer 12. Details concerning the configuration and operation of the characterization apparatus 10 will be described later.

The computer 12 is a versatile personal computer, and performs information processing such as the tallying, analysis and display of data acquired from the characterization apparatus 10. The computer 12 may also be used to control the operation of the characterization apparatus 10. In addition, the display unit of the computer 12 may be used to display the contents of the characterization result of the characterization apparatus 10.

The thermometer 14 is arranged on the back side of the solar cell module 200, and is used for detecting the temperature of such back side. Here, the term "back side" refers to the face that is opposite the acceptance surface (face to receive the solar light) of the solar cell module 200. For instance, a thermocouple is used as the thermometer 14. The thermometer 14 is disposed near the center of the back side of the solar cell module 200. The detection signal (temperature detection result) of the thermometer 14 is input to the characterization apparatus 10 via a wiring.

The actinometer 16 is disposed so that the condition of the incoming radiation of solar light is the same as the solar cell module 200; for instance, the actinometer 16 is disposed at a position that is adjacent to the solar cell module 200. For instance, a pyranometer is used as the actinometer 16. The detection signal (insolation detection result) of the actinometer 16 is input to the characterization apparatus 10 via a wiring.

The reference cell 18 is disposed and used similar to the actinometer 16. The detection signal of the reference cell 18 is input to the characterization apparatus 10 via a wiring. In particular, by using a reference cell having similar characteristics as the solar cell to be measured as the reference cell 18, a more accurate conversion into the reference condition can be conducted.

The thermometer 20 is arranged at a location that is adjacent to the solar cell module 200, and is used for detecting the outside air temperature. For instance, a radiation thermometer is used as the thermometer 20. The detection signal (temperature detection result) of the thermometer 14 is input to the characterization apparatus 10 via a wiring.

The wireless sensor converter 22 converts the respective output signals of the thermometers 14, 20, the actinometer 16, and the reference cell 18 into a wireless communication signal, and sends this to the characterization apparatus 10. The wireless sensor converter 22 is prepared as an option, and may be omitted. By using wireless communication, wiring between the thermometers 14, 20, actinometer 16, reference cell 18 and the characterization apparatus 10 is no longer necessary, and there is an advantage in that the characterization can be performed more easily.

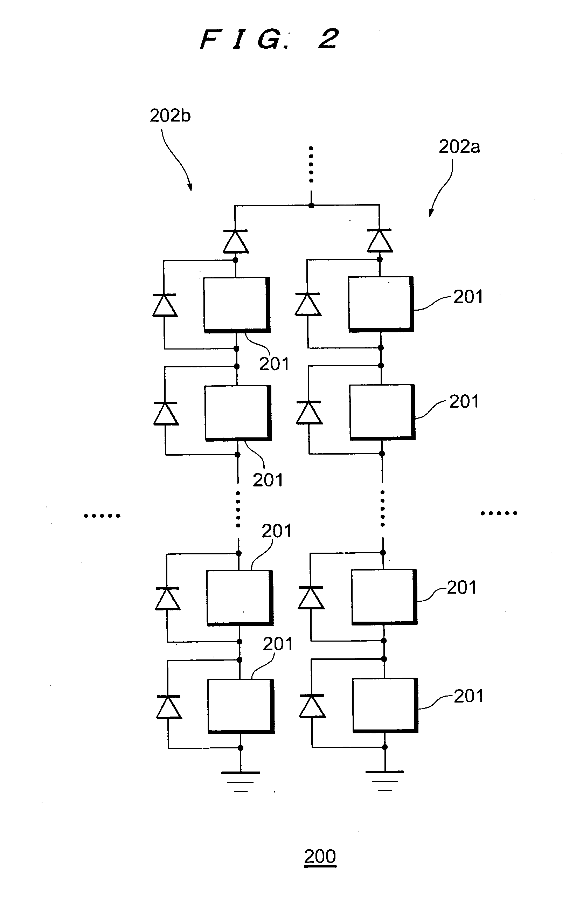

Fig. 2 is a diagram explaining a circuit configuration example of the solar cell module 200. Each solar cell panel 201 is configured by including one or more solar cells. Each panel group 202a, 202b is configured by serially connecting each of the plurality of solar cell panels 201. The solar cell module 200 of this embodiment that is configured by connecting the panel groups 202a, 202b in parallel is configured by containing one or more modules configured by connecting two panel groups 202a, 202b in parallel. The characterization apparatus 10 is connected to either end of these modules to measure the voltage and current. Incidentally, the circuit configuration of the solar cell module 200 is not limited thereto.

The characterization apparatus 10 is described in further detail below.

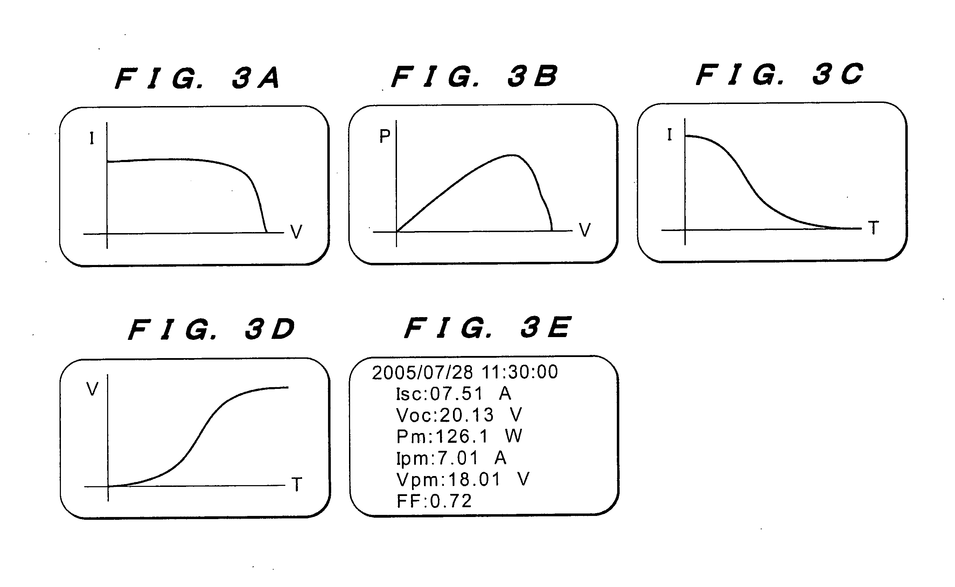

Fig. 3 is a diagram schematically explaining the function of the characterization apparatus 10. Fig. 3 shows a display screen example in the display unit of the characterization apparatus 10. The characterization apparatus 10 of this embodiment comprises, with respect to the solar cell module 200, (1) a function for measuring the current-voltage characteristic (I-V characteristic), (2) a function for measuring the power-voltage characteristic (P-V characteristic), (3) a function for measuring the current-time characteristic (I-T characteristic), and (4) function for measuring the voltage-time characteristic (V-T characteristic). Fig. 3A shows a display example of the I-V characteristic, Fig. 3B shows a display example of he P-V characteristic, Fig. 3C shows a display example of the I-T characteristic, Fig. 3D shows a display example of the V-T characteristic, and Fig. 3E shows a display example of numerical data, respectively.

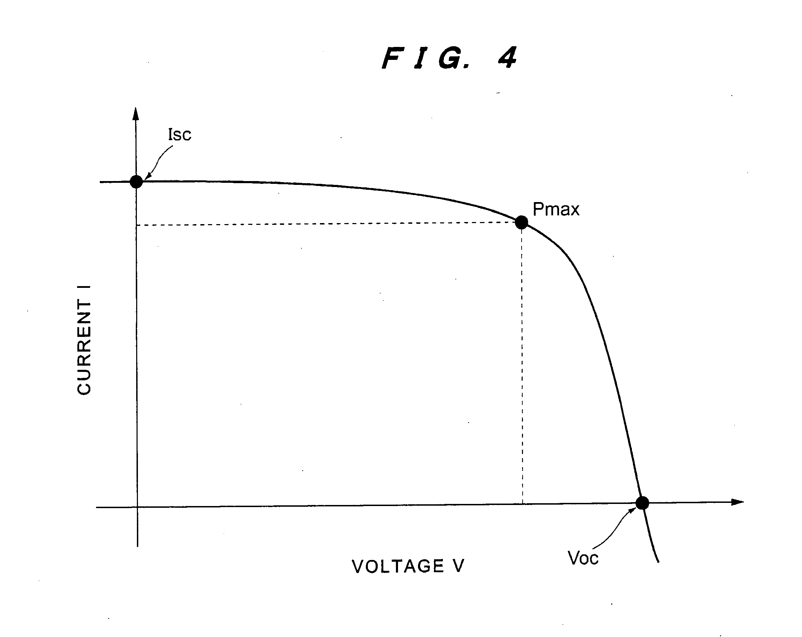

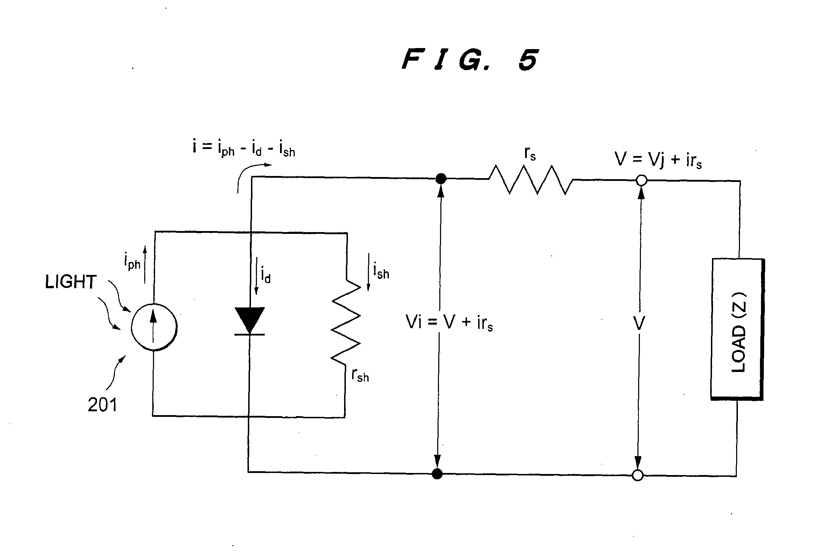

Fig. 4 is a diagram explaining the details concerning the current-voltage characteristic (I-V characteristic). The I-V characteristic, which is one type of photovoltaic device characterization reference, is the characteristic of the current and voltage obtained from the output port of the photovoltaic device when irradiating light on the photovoltaic device and changing the voltage of the load. As shown in Fig. 4, as important parameters for evaluating the photovoltaic device performance, there are short-circuit current Isc, open voltage Voc, maximum output power Pmax, and so on. The short-circuit current Isc is the current that flows when the output port of the photovoltaic device is short-circuited. Based on the value of this short-circuit current Isc, it is possible to evaluate the capacity of the photovoltaic device to apply electrical current. The open voltage Voc is the voltage when the load is not connected to the output port of the photovoltaic device (unloaded condition). Based on the value of this open voltage Voc, it is possible to evaluate the capacity of the photovoltaic device to generate voltage. The maximum output power Pmax is the output value when the power reaches its maximum upon computing the power P, which is the product of current and voltage in the I-V characteristic curve. Here, an equivalent circuit of the photovoltaic device is shown in Fig. 5. The I-V characteristic can be obtained by measuring the voltage v and current i on either side of the load while changing the load (Z) regarding the solar cell panel 201 shown in Fig. 5. Since the integrated value of the voltage and current is the power, operation of the photovoltaic device where the power value becomes maximum (refer to dotted line of Fig. 4) will be the efficient usage of such photovoltaic device. The characterization apparatus 10 of this embodiment measures the I-V characteristic and calculates the P-V characteristic from the obtained data in order to calculate the maximum output power Pmax.

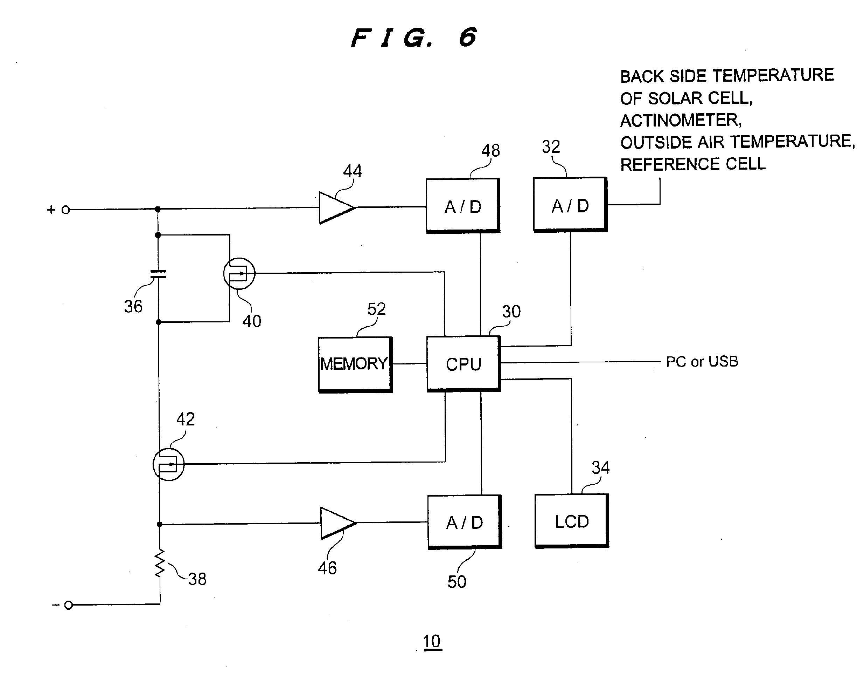

Fig. 6 is a block diagram explaining the detailed configuration of the characterization apparatus 10. The characterization apparatus 10 shown in Fig. 6 is configured from a CPU (Central Processing Unit) 30, analog to digital converters (A/D) 32, 48, 50, an LCD unit (LCD) 34, a capacitive element (capacitor) 36, a resistive element 38, transistors 40, 42, operational amplifiers 44, 46, and a memory 52.

The CPU 30 controls the operation of the overall characterization apparatus 10. Details concerning the CPU 30 will be explained later.

The A/D converter 32 converts the output signal (back side temperature of the solar cell) of the thermometer 14, the output signal of the actinometer 16, the output signal (outside air temperature) of the thermometer 20, and the output signal of the reference cell into a digital signal, respectively. The digital signal is input to the CPU 30.

The LCD unit 34 is supplied with image signals from the CPU 30, and displays images corresponding to the image signals. A specific example of the displayed contents is as described above (refer to Fig. 3). The display unit may be configured with a display device other than LCD (for instance, EL device, electrophoretic device, etc.).

The capacitive element 36 and the resistive element 38 are connected serially as shown in Fig. 6, and connected between the output ports (+, -) of the solar cell module 200. The characterization apparatus 10 of this embodiment uses the capacitive element 36 as the load, and measures the various characteristics such as the I-V characteristic of the solar cell panel by using the charge/discharge of the capacitive element 36.

With respect to the transistor 40, the gate is connected to the CPU 30, and the source and drain are respectively connected to either end of the capacitive element 36. The transistor 40 is switched between an ON state and an OFF state upon receiving a control signal that is supplied from the CPU 30 to the gate.

With respect to the transistor 42, the gate is connected to the CPU 30, and the source-drain path is connected serially between the capacitive element 36 and the resistive element 38. By switching between an ON state and an OFF state upon receiving a control signal that is supplied from the CPU 30 to the gate, the transistor 42 functions as a switch for opening and closing a current path configured from the capacitive element 36 and the resistive element 38.

The operational amplifier 44 amplifies the voltage represented with one input port (+) of the characterization apparatus 10. The amplified voltage signal is converted into a digital signal with the A/D converter 48, and imported into the CPU 30.

The operational amplifier 46 amplifies the voltage represented with one end (termination on the side that is not connected to the other input port of the characterization apparatus) of the resistive element 38. The amplified voltage signal is converted into a digital signal with the A/D converter 50, and imported into the CPU 30.

The memory 52 stores various data required for the CPU 30 to perform characterization of the solar cell module 200. As the memory 52, for instance, used may be a ROM (Read Only Memory), nonvolatile RAM capable of retaining and rewriting data, or a hard disk device. Here, the characterization apparatus 10 of this embodiment performs characterization by fitting the data of the reference characteristics stored beforehand in the memory 52 and the data of the I-V characteristic obtained from the solar cell module 200. In addition to the data of the reference characteristics described above, the memory 52 also stores data of the measured I-V characteristic. The memory 52 is able to store roughly 300 sets of I-V characteristic data.

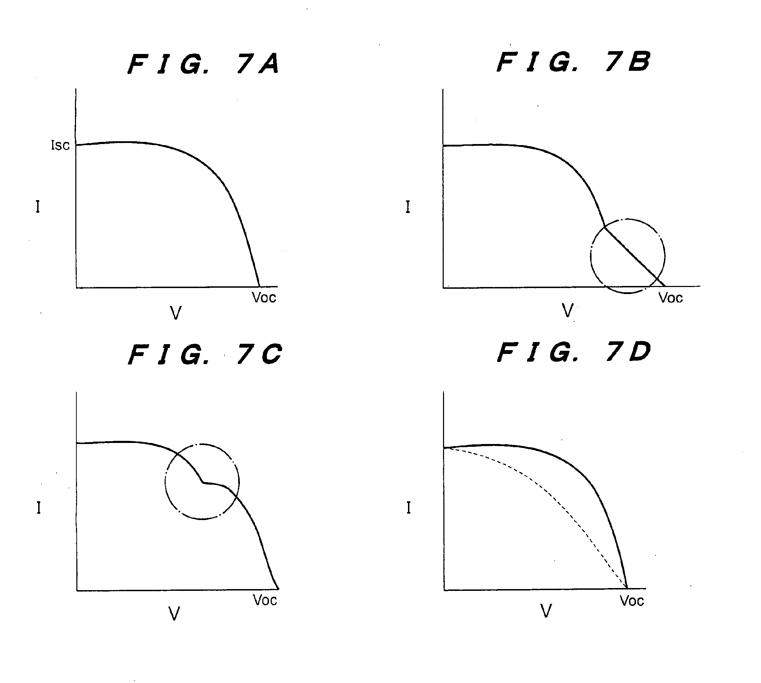

Fig. 7 is a conceptual diagram explaining the data of the reference characteristics stored in the memory 52. Fig. 7A is a graph showing the I-V characteristic (normal characteristic) that is fundamentally found in a solar cell. This characteristic curve corresponds to Fig. 4 described above. Fig. 7B is a graph showing a typical I-V characteristic when a disconnection or short circuit has occurred in the solar cell module, the panel, or the individual solar cell cells configuring the panel. This characteristic curve is characterized in that a distinct changing point (polygonal line) occurs near the open voltage Voc (refer to portion of dashed line). Fig. 7C is a graph showing a typical I-V characteristic in a case where a part of the solar cell module is shadowed due some kind of external cause (e.g., an obstacle), and the electricity generated at such portion has decreased. This characteristic curve is characterized in that the curve is separated into two stages as a result of the I-V characteristic dropping at a certain distinct changing point (refer to portion of dashed line). Fig. 7D is a graph showing a typical I-V characteristic when a decrease in output is occurring to the solar cell module due to time degradation. This I-V characteristic is characterized in that the original I-V characteristic shown with the solid line has changed to the I-V characteristic shown with a dotted line in which the overall output has decreased. Although the determination of aged deterioration during the actual measurement is difficult since the output characteristics are affected by weather and the like, by using the reference condition conversion formula described in JIS, the condition of degradation can be figured out since it will be possible to compare the characteristic of the solar cell module upon installation and the current characteristic.

Incidentally, the foregoing CPU 30, the capacitive element 36, the resistive element 38, the transistors 40, 42, the operational amplifiers 44, 46, and the A/D converters 48, 50 correspond to the "measurement unit," the CPU 30 corresponds to the "conversion unit" and the "determination unit," and the LCD unit 34 corresponds to the "display unit."

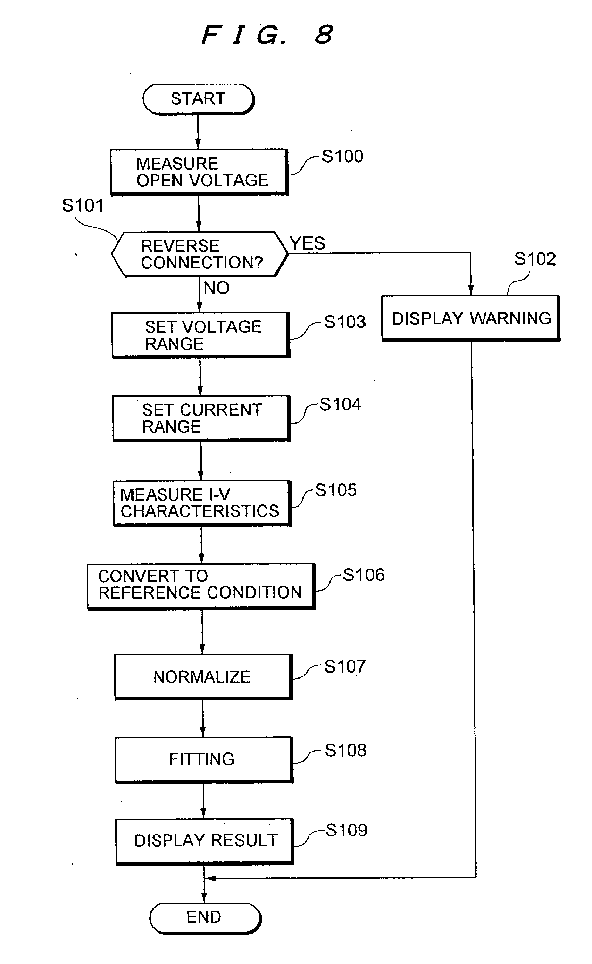

The solar cell module characterization system of this embodiment is configured as described above. The operation of the characterization apparatus 10 is now explained with reference to a flowchart. Fig. 8 is a flowchart explaining the operation routine of the characterization apparatus 10.

Foremost, the CPU 30 measures the open voltage of the connected solar cell module 200 (step S100). Specifically, the CPU 30 switches the transistor 42 to an OFF state (status where source and drain are non-conducting) by supplying a control signal. While maintaining this status, the CPU 30 imports the digital signal output from the A/D converter 48. This digital signal shows the voltage of one input port (+) of the characterization apparatus; that is, it shows the open voltage.

Subsequently, the CPU 30 determines whether the solar cell module 200 is in a reverse connection based on the value of the acquired open voltage (step S101). Specifically, if the solar cell module 200 is in a reverse connection, since the value of the open voltage will be approximately zero or a negative value, the CPU 30 determines whether the open voltage is a positive value. It is also possible to provide a given threshold value (several volts in the case of a positive value), and determine that the solar cell module 200 is not in a reverse connection if the open voltage is greater than the threshold value.

If the solar cell module 200 is in a reverse connection (step S101: YES), the CPU 30 displays a prescribed warning screen on the LCD unit 34 (step S102). Like this, if the solar cell module 200 is in a reverse connection, by displaying a warning display and preventing the user from subsequently measuring the current or the like, the characterization apparatus 10 can be prevented from malfunctioning.

If the solar cell module 200 is not in a reverse connection (step S101: NO), the CPU 30 sets the voltage range (step S103). In the setting of the voltage range, the gain of the operational amplifier 44 is set according to a command from the CPU 30. The gain of the operational amplifier 44 is selected from, for instance, a gain of 1, 1/10, or 1/100.

Subsequently, the CPU 30 measures the current maximum range, and optimally sets the current range based on this value (step S104). Specifically, the CPU 30 switches the respective transistors 40, 42 to an ON state (state where the source and drain are conducting) by supplying a control signal. As a result of switching the transistor 40 to an ON state, the current output from the solar cell module 200 will flow without going through the capacitive element 36 (i.e., without the electrical charge being charged to the capacitive element 36). While maintaining this status, the CPU 30 imports the digital signal output from the A/D converter 50. This digital signal shows the potential of one end of the resistive element 38, and the current value is measured indirectly by measuring this potential. Here, in the setting of the current range, the gain of the operational amplifier 46 is set according to a command from the CPU 30. The gain of the operational amplifier 46 is selected from, for instance, a gain of 1, 10, or 100.

Subsequently, the CPU 30 measures the I-V characteristic (step S105). Specifically, the CPU 30 switches the transistor 40 to an OFF state (a state where the source and drain are non-conducting) by supplying a control signal, and switching the transistor 42 to an ON state (a state where the source and drain are conducting) by supplying a control signal. While maintaining this status, the CPU 30 imports the digital signals output respectively from the A/D converters 48, 50. Here, the electrical charge from the solar cell module 200 is charged to the capacitive element 36, and gradually approaches the open voltage. This change of voltage is sequentially imported into the CPU 30 via the operational amplifier 44 and the A/D converter 48. Pursuant to the charging to the capacitive element 36, the current flowing in the resistive element 38 will gradually decrease. This change of current is sequentially imported into the CPU 30 via the operational amplifier 46 and the A/D converter 50. When the value of this current becomes extremely small (for instance, 1/100 to 1/1000 of the short-circuit current Isc), the CPU 30 switches the transistor 42 to an OFF state, and ends the measurement of the I-V characteristic. The CPU 30 stores the data of the measured I-V characteristic in the memory 52.

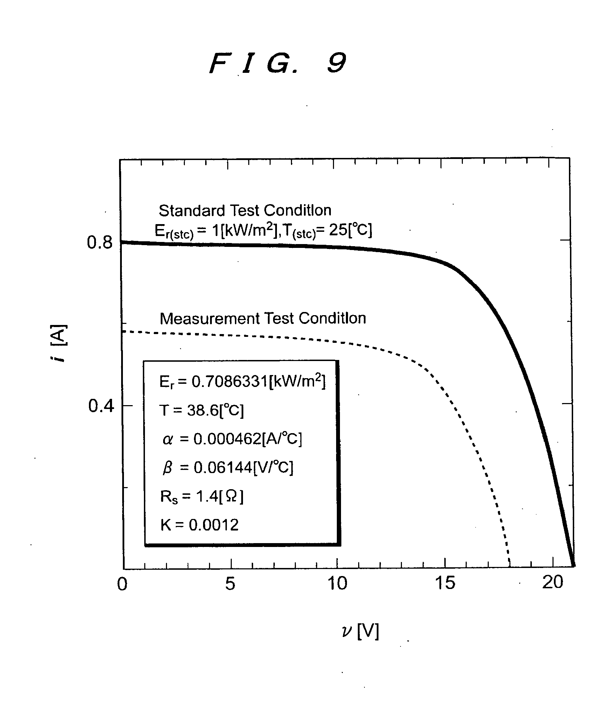

Subsequently, the CPU 30 converts the measured I-V characteristic to a reference condition of 1kW/$m^2$, 25°C (step S106). For this conversion, the back side temperature, the solar intensity (obtained based on the actinometer 16 and the reference cell 18), and the outside air temperature of the solar cell module 200 acquired via the A/D converter 32 are used. The conversion method is based on JIS-C8913. Specifically, the I-V characteristic is converted as follows. As shown in Fig. 9, in the reference condition, when the voltage is $Vd_{(stc)}$, the current is $Id_{(stc)}$, the solar intensity is $Er_{(stc)}$, the solar cell temperature is $T_{(stc)}$, the measured voltage is Vd, the current is Id, the solar intensity is Er, the solar cell temperature is T, and the short-circuit current is Isc, as a result of using the following conversion formula, the measurement result can be converted respectively to reference voltage $Vd_{(stc)}$ and reference current $Id_{(stc)}$.

$$Id_{(stc)}[A]=Id+Isc((Er_{(stc)}/Er)-1)+\alpha(T_{(stc)}-T)$$

$$Vd_{(stc)}[V]=Vd+\beta(T_{(stc)}-T)-Rs(Id_{(stc)}-Id)-K\cdot Id_{(stc)}(T_{(stc)}-T)$$

Provided,

Rs: series resistance [$\Omega$]
K: curve compensation factor
$\alpha$: current temperature coefficient [A/°C]
$\beta$: voltage temperature coefficient [V/°C]

Subsequently, the CPU 30 normalizes the data of the I-V characteristic converted into the reference condition so that the short-circuit current Isc and the open voltage Voc (refer to Fig. 4) respectively become 1 (step S107).

Subsequently, the CPU 30 reads the data (refer to Fig. 7) of the reference characteristics stored in the memory 52, compares the reference characteristics and the data of the I-V characteristic normalized at step S107, and performs processing (curve fitting) for selecting the reference characteristic with the least error (step S108). The evaluation of errors between each reference characteristic data and the data of the normalized I-V characteristic is conducted, for example, using the least square method. Thereby, for instance, if the I-V characteristic is closest (i.e., least errors) to the reference characteristic shown in Fig. 7B, it is determined that a disconnection or a short circuit has occurred in the panel or solar cell included in the solar cell module 200 to be evaluated. The CPU 30 displays this result on the LCD unit 34 (step S109). The sequential characterization processing is thereby ended.

INDUSTRIAL APPLICABILITY

As described above, according to the present embodiment, it is possible to individually estimate and detect the decrease in output of a photovoltaic device caused by wiring errors, ambient environment such as neighboring trees or buildings, time degradation and various other factors. Thus, it is possible to conduct a more detailed failure diagnosis of a photovoltaic device or the system using such photovoltaic device.

Incidentally, the present invention is not limited to the foregoing embodiment, and may be worked in various modifications within the gist of this invention. For instance, although the characterization apparatus 10 of the foregoing embodiment adopted the capacitor load method as the method of detecting the I-V characteristic, the detection method is not limited thereto, and various other methods such as the X-Y recorder method, bias supply method, and electronic load method may also be adopted.

**Claims**

1.   A photovoltaic device characterization apparatus, comprising:

   a measurement unit for measuring a current-voltage characteristic of a photovoltaic device;
   a conversion unit for converting the current-voltage characteristic measured with the measurement unit into a prescribed reference condition;
   a memory for storing a plurality of reference characteristics; and
   a determination unit for comparing the current-voltage characteristic converted into the reference condition and the reference characteristics read from the memory, and determining to which one of the reference characteristics the current-voltage characteristic is closest.

2.   The photovoltaic device characterization apparatus according to claim 1, further comprising a display unit for displaying subject matter of the determination of the determination unit.

3.   The photovoltaic device characterization apparatus according to claim 1,
   wherein the conversion unit converts the current-voltage characteristic into a reference condition of $1kW/m^2$, 25°C.

4.   The photovoltaic device characterization apparatus according to claim 1,
   wherein the conversion unit acquires the back side temperature and solar intensity of the photovoltaic device, and performs the conversion into the reference condition based on the acquired back side temperature and solar intensity.

5.   The photovoltaic device characterization apparatus according to claim 1,
   wherein the conversion unit additionally performs processing for normalizing the current-voltage characteristic.

6.   The photovoltaic device characterization apparatus according to claim 1,
   wherein the determination unit compares the current-voltage characteristic and the reference characteristics based on a least square method.

7.   The photovoltaic device characterization apparatus according to claim 1,
   wherein the measurement unit measures the open voltage before measuring the current of the photovoltaic device, and does not measure the current if the open voltage shows an abnormal value.

8.   The photovoltaic device characterization apparatus according to claim 1,
   wherein the measurement unit sets a voltage range by measuring the open voltage of the photovoltaic device, subsequently measures the current in a maximum range upon connecting a load to the photovoltaic device, and sets the current range based on the obtained value.

# *F I G.  1*

100

# F I G. 2

200

## FIG. 3A

I ... V

## FIG. 3B

P ... V

## FIG. 3C

I ... T

## FIG. 3D

V ... T

## FIG. 3E

```
2005/07/28 11:30:00
   Isc:07.51  A
   Voc:20.13  V
   Pm:126.1  W
   Ipm:7.01  A
   Vpm:18.01  V
   FF:0.72
```

F I G. 4

# F I G. 5

# F I G. 6

BACK SIDE TEMPERATURE
OF SOLAR CELL,
ACTINOMETER,
OUTSIDE AIR TEMPERATURE,
REFERENCE CELL

PC or USB

10

EP 2 019 433 A1

## F I G.  7A

I

Isc

V    Voc

## F I G.  7B

I

V    Voc

## F I G.  7C

I

V    Voc

## F I G.  7D

I

V    Voc

EP 2 019 433 A1

# F I G.  8

START

MEASURE OPEN VOLTAGE — S100

S101 — REVERSE CONNECTION? — YES → DISPLAY WARNING — S102

NO

SET VOLTAGE RANGE — S103

SET CURRENT RANGE — S104

MEASURE I-V CHARACTERISTICS — S105

CONVERT TO REFERENCE CONDITION — S106

NORMALIZE — S107

FITTING — S108

DISPLAY RESULT — S109

END

# F I G. 9

Standard Test Condition
$E_{r(stc)} = 1[kW/m^2], T_{(stc)} = 25[^\circ C]$

Measurement Test Condition

$E_r = 0.7086331[kW/m^2]$

$T = 38.6[^\circ C]$

$\alpha = 0.000462[A/^\circ C]$

$\beta = 0.06144[V/^\circ C]$

$R_s = 1.4[\Omega]$

$K = 0.0012$

$i$ [A]

$\nu$ [V]

## INTERNATIONAL SEARCH REPORT

| | International application No. |
|---|---|
| | PCT/JP2007/058273 |

A.  CLASSIFICATION OF SUBJECT MATTER
*H01L31/04*(2006.01)i

According to International Patent Classification (IPC) or to both national classification and IPC

B.  FIELDS SEARCHED

Minimum documentation searched (classification system followed by classification symbols)
H01L31/04

Documentation searched other than minimum documentation to the extent that such documents are included in the fields searched
Jitsuyo Shinan Koho          1922-1996    Jitsuyo Shinan Toroku Koho    1996-2007
Kokai Jitsuyo Shinan Koho     1971-2007    Toroku Jitsuyo Shinan Koho    1994-2007

Electronic data base consulted during the international search (name of data base and, where practicable, search terms used)

C.  DOCUMENTS CONSIDERED TO BE RELEVANT

| Category* | Citation of document, with indication, where appropriate, of the relevant passages | Relevant to claim No. |
|---|---|---|
| Y | JP 8-278354 A  (Shikoku Research Institute Inc.), 22 October, 1996 (22.10.96), Par. Nos. [0010] to [0016], [0025], [0041] to [0049]; Fig. 1 (Family: none) | 1-8 |
| Y | JP 2006-39634 A  (Nagano Nihon Musen Kabushiki Kaisha), 09 February, 2006 (09.02.06), Par. No. [0006]; Fig. 6 (Family: none) | 1-8 |
| Y | JP 56-105865 U  (Matsushita Electric Industrial Co., Ltd.), 18 August, 1981 (18.08.81), Full text; all drawings (Family: none) | 1-8 |

☒  Further documents are listed in the continuation of Box C.          ☐  See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered   to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 11 July, 2007 (11.07.07) | 24 July, 2007 (24.07.07) |

| Name and mailing address of the ISA/ | Authorized officer |
|---|---|
| Japanese Patent Office | |
| Facsimile No. | Telephone No. |

Form PCT/ISA/210 (second sheet) (April 2005)

**INTERNATIONAL SEARCH REPORT**

International application No.

PCT/JP2007/058273

C (Continuation).  DOCUMENTS CONSIDERED TO BE RELEVANT

| Category* | Citation of document, with indication, where appropriate, of the relevant passages | Relevant to claim No. |
|---|---|---|
| Y | JP 2004-77309 A  (Atsushi IGA),<br>11 March, 2004 (11.03.04),<br>Full text; all drawings<br>(Family: none) | 1-8 |

Form PCT/ISA/210 (continuation of second sheet) (April 2005)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **TAKASHIMA et al.** Fundamental Review of Failure Diagnosis Method of Photovoltaic Array. *Collected Papers of Lectures Concerning Solar/Wind Power Generation,* 2003, vol. 105, 425-428

- **NISHIZAWA ; RIKO TOSHO K.K. et al.** *Rudiments of Photovaltaic Power Generation and Residential Application,* 1998, 159